# FASCICULE DE BREVET EUROPEEN

(11) **EP 3 498 564 B1**
(45) Date de publication et mention de la délivrance du brevet: **13.10.2021**
(21) Numéro de dépôt: 18212460.2
(22) Date de dépôt: 13.12.2018
(51) Int. Cl.: B61D 17/04

(54) **PROCÉDÉ D'ASSEMBLAGE D'UNE CAISSE DE VÉHICULE FERROVIAIRE**
VERFAHREN ZUM ZUSAMMENBAU DER KAROSSERIE EINES SCHIENENFAHRZEUGS
METHOD FOR ASSEMBLING A RAILWAY VEHICLE BODY

(30) Priorité: 13.12.2017 FR 1762080
(43) Date de publication de la demande: 19.06.2019
(73) Titulaire: ALSTOM Transport Technologies, 93400 Saint-Ouen (FR)
(72) Inventeur: AWTUCH, Bernard, 59230 Château-L'Abbaye (FR)
(74) Mandataire: Lavoix

(56) Documents cités:
- WO-A1-2004/058553
- GERHARD T ET AL: "ERFAHRUNGSBERICHT ESIE.CAR - MODULARES WAGENKASTENKONZEPT FUER WIRTSCHAFTLICHE REGIONALTRIEBZUEGE DER ZUKUNFT//EXPERIENCE REPORT ESIE-CAR - MODULAR CARBODY-CONCEPT FOR ECONOMICAL FUTURE REGIONAL TRAINS-SETS", ZEVRAIL - GLASERS ANNALEN, GEORG SIEMENS VERLAG, BERLIN, DE, vol. 129, no. 10, 1 octobre 2005 (2005-10-01), page 404, XP001234557, ISSN: 1618-8330
- ALTENBURG K ET AL: "ESIE.CAR - DIE INNOVATIVE WAGENKASTENTECHNOLOGIE FUER WIRTSCHAFTLICHE REGIONALZUEGE VON SIEMENS//ESIE.CAR - THE INNOVATIVE MODULAR CAR BODY TECHNOLOGY FOR ECONOMICAL REGIONAL TRAINSETS FROM SIEMENS", ZEVRAIL - GLASERS ANNALEN, GEORG SIEMENS VERLAG, BERLIN, DE, vol. 128, 1 juin 2004 (2004-06-01), pages 208-215, XP001196845, ISSN: 1618-8330

## Description

La présente invention concerne un procédé d'assemblage d'une caisse de véhicule ferroviaire, la caisse comprenant au moins un module de châssis, au moins un module de paroi et au moins un module de pavillon.

L'invention s'applique plus particulièrement aux caisses de véhicules ferroviaires du type tramway, métro et trains interrégionaux.

Il est connu des caisses de véhicules ferroviaires comprenant un ou plusieurs modules de paroi, un ou plusieurs modules de châssis et un ou plusieurs modules de pavillon.

Le document WO 2004/058553 et les articles GERHARD T ET AL: "ERFAHRUNGSBERICHT ESIE.CAR - MODULARES WAGENKASTENKONZEPT FUER WIRTSCHAFTLICHE REGIONALTRIEBZUEGE DER ZUKUNFT // EXPERIENCE REPORT ESIE-CAR ― MODULAR CARBODY-CONCEPT FOR ECONOMICAL FUTURE REGIONAL TRAINS-SETS" et ALTENBURG K ET AL: "ESIE.CAR - DIE INNOVATIVE WAGENKASTENTECHNOLOGIE FUER WIRTSCHAFTLICHE REGIONALZUEGE VON SIEMENS // ESIE.CAR ― THE INNOVATIVE MODULAR CAR BODY TECHNOLOGY FOR ECONOMICAL REGIONAL TRAINSETS FROM SIEMENS" décrivent chacun un procédé d'assemblage d'une caisse de véhicule ferroviaire comprenant plusieurs modules.

Lors de l'assemblage de la caisse, ces modules sont connectés entre eux par exemple par soudage. Cependant, l'assemblage par soudage est susceptible d'entraîner une déformation des modules et rend ainsi difficile le processus d'assemblage de telles caisses.

Pour éviter une déformation de la caisse lors de l'assemblage, il est également connu de connecter les modules par rivetage.

Afin de réaliser ce rivetage, il est connu de contre-percer les trous de rivets lors de l'étape d'assemblage des modules. Cette technique nécessite toutefois l'utilisation d'un poste d'assemblage complexe et entraine la production de copeaux à l'étape d'assemblage des modules. Il est alors nécessaire de protéger les modules à cette étape et de limiter le pré-équipement des modules.

Une autre possibilité connue est de réaliser des trous de rivetage oblongs préalablement à l'étape d'assemblage des modules, permettant ainsi d'avoir une tolérance sur le positionnement des trous de rivetage. Cependant, ce procédé nécessite lui aussi un poste d'assemblage complexe, de même que la présence de plusieurs opérateurs afin de maintenir les modules en position pour pouvoir effectuer le rivetage correctement, et n'offre pas une qualité d'assemblage optimale.

Un but de l'invention est d'obtenir un procédé d'assemblage de caisse simplifié, tout en garantissant un assemblage optimisé et précis des modules.

A cet effet, l'invention a pour objet un procédé d'assemblage selon la revendication 1.

Selon des modes de réalisation particuliers de l'invention, le procédé d'assemblage présente également une ou plusieurs des caractéristiques des revendications 2 à 9.

D'autres caractéristiques et avantages de l'invention apparaîtront à la lecture de la description détaillée qui va suivre, donnée uniquement à titre d'exemple et faite en se référant aux dessins annexés, parmi lesquels :
- la figure 1 est une vue éclatée, en perspective, d'une caisse de véhicule ferroviaire ;
- la figure 2 est une vue d'un module spécifique sur lequel sont affichées les cotations des trous de fixation définies selon l'invention ;
- la figure 3 est une coupe d'un rivet monobloc à fixation aveugle en position désassemblée ;
- la figure 4 est une coupe d'un rivet monobloc à fixation aveugle en position assemblée ;
- la figure 5 est un organigramme du procédé selon l'invention.

Dans la description, les termes « sur », « sous », « au-dessus », « en-dessous », « supérieur » et « inférieur » sont définis par rapport à une direction d'élévation d'un véhicule ferroviaire lorsqu'il est disposé sur des rails, c'est-à-dire une direction sensiblement verticale lorsque le train circule sur des rails horizontaux. La direction longitudinale est définie par la direction de circulation du véhicule ferroviaire et la direction transversale est la direction sensiblement perpendiculaire à la direction longitudinale et à la direction d'élévation du véhicule ferroviaire.

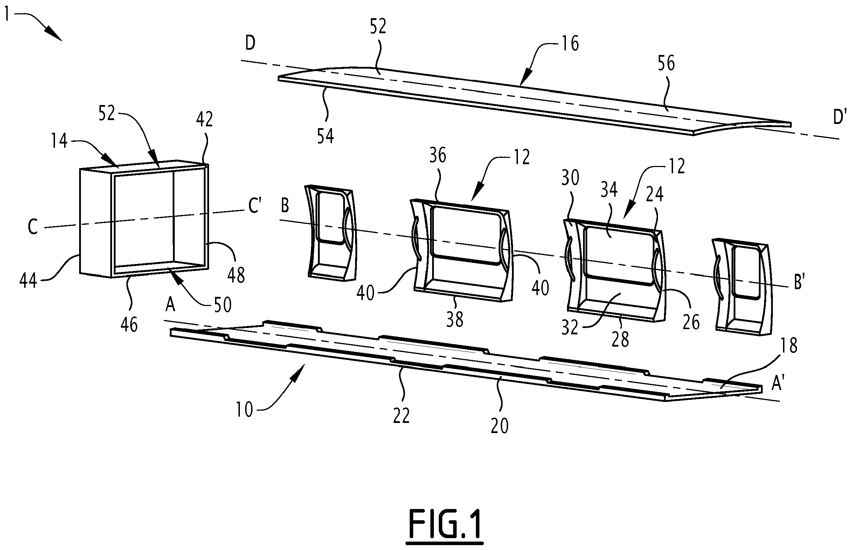

La caisse 1 de véhicule ferroviaire représentée sur la figure 1 comprend un module de châssis 10, des modules de paroi 12, des modules d'extrémité 14 et un module de pavillon 16.

On notera que, dans la figure 1, ne sont représentés que les modules de paroi 12 d'un premier côté des modules de châssis 10 et de pavillon 16, et un unique module d'extrémité 14 disposé à une première extrémité longitudinale des modules de châssis 10 et de pavillon 16. Néanmoins, la caisse 1 comprend avantageusement d'autres modules de paroi 12, non représentés, disposés symétriquement aux modules de paroi 12 visibles, du côté opposé des modules 10 et 16, et un autre module d'extrémité 14, lui aussi non représenté, disposé à une deuxième extrémité longitudinale des modules de châssis 10 et de pavillon 16 opposée à la première extrémité.

En variante, la caisse 1 comprend, de chaque côté des modules de châssis 10 et de pavillon 16, un module de paroi unique.

Les modules de châssis 10, de paroi 12, d'extrémité 14 et de pavillon 16 délimitent un espace intérieur à la caisse 1 destiné à recevoir des occupants du véhicule ferroviaire et/ou des équipements.

Dans un exemple, les modules 10, 12, 14, 16 comprennent des dispositifs électroniques, non représentés. Les modules de châssis 10, de paroi 12 d'extrémité 14 et de pavillon 16 sont, par exemple, connectés électriquement entre eux par des connecteurs, non représentés.

De préférence, au moins un des modules de châssis 10, de paroi 12, d'extrémité 14 et de pavillon 16 est un module pré-équipé. Avantageusement, tous les modules de châssis 10, de paroi 12, d'extrémité 14 et de pavillon 16 sont des modules pré-équipés.

Par « module pré-équipé », on comprend un module comprenant des composants assemblés préalablement à l'assemblage du module aux autres modules de la caisse 1.

Un module pré-équipé est, par exemple, configuré pour être contrôlé individuellement via une station de contrôle prévue à cet effet, au niveau de laquelle est par exemple contrôlée l'installation et/ou le fonctionnement correct de composants et/ou de dispositifs électroniques dudit module pré-équipé.

Le module de châssis 10 s'étend selon un plan sensiblement horizontal le long d'une direction de plus grande longueur A-A'.

La plus grande longueur du module de châssis 10, prise selon la direction A-A', est comprise entre 10 m et 20 m.

La largueur du module de châssis 10, selon une direction orthogonale à la direction A-A' est comprise entre 2 m et 3 m.

Le module de châssis 10 définit une face supérieure 18 sensiblement plane et une face inférieure 20 sensiblement plane et parallèle à la face supérieure 18.

On appelle face supérieure 18, la face du module de châssis 10 qui est tournée vers le haut de la caisse 1.

Le module de châssis 10 définit, en outre, au moins une arête 22 s'étendant parallèlement à la direction de plus grande longueur A-A' le long de l'une des faces supérieure 18 et inférieure 20.

Le module de châssis 10 est disposé en-dessous du module de pavillon 16 et est sensiblement perpendiculaire aux modules de paroi 12 et d'extrémité 14.

Le module de châssis 10 comprend, par exemple, une structure métallique configurée pour supporter le poids des occupants ou des équipements, non représentés, du véhicule ferroviaire.

Le module de châssis 10 comprend, en outre, un plancher situé sur la face supérieure 18 de la structure. Le plancher constitue typiquement une surface destiné à recevoir des occupants du véhicule ferroviaire et/ou des équipements du véhicule ferroviaire.

Le module de châssis 10 est connecté aux modules de paroi 12 et aux modules d'extrémité 14.

Chaque module de paroi 12 s'étend selon un plan sensiblement vertical, perpendiculairement à la direction transversale, le long d'une direction de plus grande longueur B-B'. La direction B-B' est parallèle à la direction A-A'.

La longueur du module de paroi 12, prise selon la direction B-B', est comprise entre 0,5 m et 3 m.

La hauteur du module de paroi 12, selon une direction orthogonale à la direction B-B' est comprise entre 1,7 m et 2,5 m.

Chaque module de paroi 12 définit une face intérieure 24 et une face extérieure 26, opposée à la face intérieure 24.

On appelle face intérieure 24, la face du module de paroi 12 qui est tournée vers l'intérieur de la caisse 1.

Le module de paroi 12 définit, en outre, au moins une arête 28 s'étendant parallèlement à la direction de plus grande longueur B-B' le long de l'une des faces intérieure 24 et extérieure 26 du module de paroi 12.

Une première partie des modules de paroi 12 forment ensemble une première paroi latérale de la caisse 1 et une deuxième partie des modules de paroi 12 forment ensemble une deuxième paroi latérale de la caisse 1, lesdites première et deuxième parois latérales délimitant l'espace intérieur 18 transversalement.

Chaque module de paroi 12 comprend une structure porteuse comprenant des montants 30 reliant chacun le module de châssis 10 au module de pavillon 16. Ces montants 30 sont constitués par exemple par des montants de porte délimitant chacun une bordure d'une porte ménagée dans l'une des parois latérales de la caisse 1.

Chaque module de paroi 12 comprend, en outre, au moins une tôle métallique 32 fixée entre deux montants 30, et au moins une fenêtre 34 montée entre deux montants 30, au-dessus d'une tôle métallique 32.

Chaque module de paroi 12 présente un bord supérieur 36, un bord inférieur 38 et des bords longitudinaux 40.

Le bord supérieur 36 est connecté au module de pavillon 16. Le bord inférieur 38 est connecté au module de châssis 10. Les connexions entre les modules 10, 12, 16 sont décrites plus en détail ci-dessous.

Les bords longitudinaux 40 sont formés par les montants 30. Au moins un des bords supérieur 36 et inférieur 38 est défini par une arête 28.

Chaque module d'extrémité 14 s'étend selon un plan sensiblement vertical, perpendiculairement à la direction transversale, le long d'une direction de plus grande longueur C-C'. La direction C-C' est orthogonale à la direction A-A'.

La plus grande longueur du module d'extrémité 14, prise selon la direction C-C', est comprise entre 2 m et 3 m.

La hauteur du module d'extrémité 14, selon une direction orthogonale à la direction C-C' est comprise entre 2 m et 2,9 m.

Chaque module d'extrémité 14 définit une face intérieure 42 et une face extérieure 44, opposée à la face intérieure 42.

On appelle face intérieure 42, la face du module d'extrémité 14 qui est tournée vers l'intérieur de la caisse 1.

Le module d'extrémité 14 définit, en outre, au moins une arête 46 s'étendant le long de la direction de plus grande longueur C-C' sur l'une de la face intérieure 42 et de la face extérieure 44 du module d'extrémité 14.

Chaque module d'extrémité 14 comprend des poutres verticales 48 et des poutres horizontales 50, 52, dont une poutre inférieure 50 et une poutre supérieure 52.

Chacune des poutres verticales 48 est connectée à un module de paroi 12 respectif, la poutre horizontale 50 est connectée au module de châssis 10, et la poutre horizontale 52 est connectée au module de pavillon 16.

Le module de pavillon 16 s'étend selon un plan sensiblement horizontal le long d'une direction de plus grande longueur D-D'. La direction D-D' est parallèle à la direction A-A'.

La plus grande longueur du module de pavillon 16, prise selon la direction D-D', est comprise entre 10 m et 20 m.

La largueur du module de pavillon 16, selon une direction orthogonale à la direction D-D' est comprise entre 2 m et 3 m.

Le module de pavillon 16 définit une face supérieure 52 et une face inférieure 54, opposée à la face supérieure 52.

On appelle face inférieure 54, la face du module de châssis 10 qui est tournée vers le bas de la caisse 1.

Le module de pavillon 16 définit, en outre, au moins une arête 56 s'étendant parallèle à la direction de plus grande longueur D-D', le long de l'une des faces supérieure 52 et inférieure 54 du module de pavillon 16.

Le module de pavillon 16 comprend, par exemple, une structure voûtée et une tôle fixée sur la structure voûtée, non représentées.

Le module de pavillon 16 est connecté au bord supérieur 36 de chaque module de paroi 12 et à la poutre supérieure 52 de chaque module d'extrémité 14.

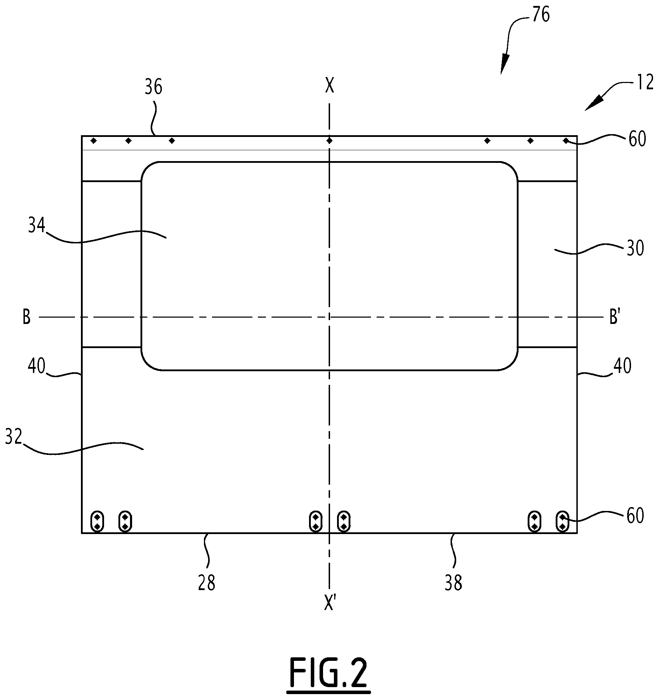

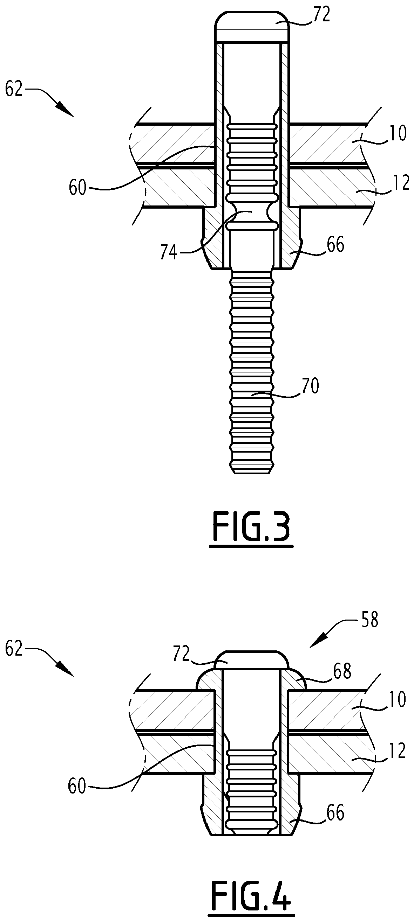

La caisse 1 comprend également des moyens de fixation 58 (Figure 4) insérés dans des trous de fixations 60 (Figure 2) ménagés dans les modules 10, 12, 14, 16, lesdits moyens de fixation 58 assurant la liaison des différents modules 10, 12, 14, 16 entre eux.

En particulier, pour chaque paire de modules 10, 12, 14, 16 adjacents, lesdits modules 10, 12, 14, 16 sont assemblés l'un à l'autre par au moins un moyen de fixation 58 introduit dans un trou de fixation 60 respectif de chacun desdits modules 10, 12, 14, 16, comme illustré sur la figure 4.

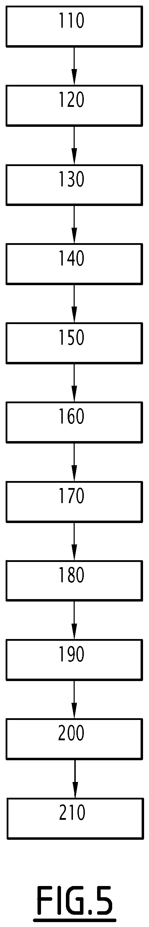

Un procédé d'assemblage de la caisse 1, illustré sur la figure 5, va à présent être décrit.

Le procédé d'assemblage de la caisse 1 comprend une première étape 110 de création d'un modèle numérique d'au moins un module spécifique 76 parmi les modules de châssis 10, de paroi 12, d'extrémité 14 et de pavillon 16.

Le modèle numérique est créé, par exemple, au moyen d'un logiciel de Conception Assistée par Ordinateur dit « CAO ».

Avantageusement, chacun des modules de châssis 10, de paroi 12, d'extrémité 14 et de pavillon 16 constitue un tel module spécifique 76.

La position des trous de fixation 60 dans le module spécifique 76 est cotée dans le modèle numérique lors d'une étape 120.

La cotation de chaque trou de fixation 60 est définie au moins par rapport à une arête 22, 28, 46, 56 du module spécifique 76 s'étendant selon la direction de plus grande longueur A-A', B-B', C-C', D-D' du module spécifique 76 et par rapport à un axe transversal X-X' à la direction de plus grande longueur du module spécifique 76. L'axe transversal X-X' est distinct des arêtes du module spécifique 76.

Avantageusement, l'axe transversal X-X' est un axe médian du module spécifique 76.

Sur l'exemple illustré par la figure 2, le module spécifique 76 est un module de paroi 12. L'arête 28 utilisée pour la cotation des trous de fixation 60 de ce module de paroi 12 est constituée par l'arête 28 située sur le bord inférieur 38 du module de paroi 12.

Dans un mode de réalisation avantageux, le procédé d'assemblage comprend une étape de calcul 130 de tenue des organes de fixation 58 au cisaillement.

Cette étape 130 comprend la simulation des efforts extérieurs susceptibles de s'appliquer sur la caisse 1, et le calcul du cisaillement résultant s'appliquant sur les moyens de fixation 58.

Puis, lors d'une étape 140, le module spécifique 76 est fourni.

Avantageusement, le procédé d'assemblage comprend une étape 150 de pré-équipement du module spécifique, au cours de laquelle les composants du module spécifique 76 sont assemblés.

Chaque module spécifique 76 pré-équipé est ensuite, de préférence, contrôlé via une station de contrôle. Par exemple, l'installation ou le fonctionnement correct des composants du module pré-équipé est contrôlé.

Le procédé d'assemblage comprend ensuite avantageusement une étape 160 de dégauchissage du module spécifique 76 afin d'aplatir le module spécifique 76, notamment au niveau de zones destinées à recevoir les trous de fixation, afin notamment de permettre un assemblage optimisé des modules spécifiques 76.

Le module spécifique 76 est ensuite positionné sur un dispositif de perçage, lors d'une étape 170.

Le dispositif de perçage est avantageusement une machine-outil à commande numérique.

Par commande numérique, on entend l'ensemble des matériels et logiciels ayant pour fonction de donner des instructions de mouvements aux organes de la machine-outil, en particulier à la tête de fraisage.

En particulier, la machine-outil à commande numérique est contrôlée au moyen du modèle numérique du module spécifique 76 et d'un logiciel de Fabrication Assisté par Ordinateur dit « FAO » définissant le trajet à parcourir par la tête de fraisage de la machine-outil.

Le procédé comprend ensuite une étape 180 de localisation des extrémités du module spécifique 76 suivant la direction de plus grande longueur de ce dernier relativement à un référentiel de la machine-outil à commande numérique. La machine-outil à commande numérique connait ainsi la position exacte du module spécifique 76 relativement à ladite machine.

Avantageusement, la localisation des extrémités est effectuée par palpage.

Puis, lors d'une étape 190, les trous de fixation 60 sont percés dans le module spécifique 76 par la machine-outil à commande numérique à la position cotée dans le modèle numérique.

La tête de fraisage de la machine-outil à commande numérique se positionne tout d'abord au niveau d'un axe de référence parmi l'arête 22, 28, 46, 56 et l'axe transversal X-X' du module spécifique 76. Puis la tête de fraisage se déplace orthogonalement à l'axe de référence et réalise les trous de fixation 60 aux emplacements définis par les cotations.

L'erreur de positionnement de la machine-outil augmente avec la distance parcourue par la machine-outil depuis l'axe de référence. Toutefois, les trous de fixation 60 étant cotés par rapport à un axe médian du module spécifique 76 et non à partir d'un des bords latéraux, l'erreur de positionnement est ainsi réduite. En particulier pour les modules de châssis 10 et de pavillon 16 qui s'étendent jusqu'à plus de 15 m, la cotation par rapport à l'axe transversal X-X' médian permet un gain important sur la tolérance de fabrication.

Avantageusement, chaque trou de fixation 60 est ainsi percé à une distance de la position cotée dans le modèle numérique avec une tolérance de localisation de diamètre 0,25 mm.

En variante, l'étape 150 de pré-équipement est réalisée après l'étape 190 de perçage.

L'étape 190 est suivie d'une étape 200, lors de laquelle la caisse 1 est assemblée par fixation des modules de châssis 10, de paroi 12, d'extrémité 14 et de pavillon 16 entre eux.

Cet assemblage comprend la fixation du module spécifique 76 à ses modules adjacents au moyen des organes de fixation 58, que l'on insère dans les trous de fixation 70 percés dans le module spécifique 76.

Avantageusement, les moyens de fixations 58 utilisés à cet effet sont dimensionnés pour résister, pendant toute la durée de vie programmée de la caisse 1, aux contraintes de cisaillement calculées lors de l'étape 130.

Par ailleurs, ces moyens de fixation 58 sont de préférence constitués par des rivets 62.

Lorsque ces rivets 62 sont fournis pour insertion dans les trous de fixation 60, ils sont encore dans une configuration désassemblée, représentée sur la figure 3, dans laquelle ils sont à l'écart des trous de fixation 60. Chaque rivet 62 ne comprend alors qu'une partie cylindrique apte à être insérée dans un trou de fixation 60, et une première tête 66 ayant extension radiale plus grande que le diamètre dudit trou de fixation 60.

Ensuite, la partie cylindrique de chaque rivet 62 est introduite dans les trous de fixation 60 d'au moins deux modules 10, 12, 14, 16 distincts, et est déformée de sorte à former sur la deuxième extrémité de ladite partie cylindrique une deuxième tête 68 ayant une extension radiale plus grande que le diamètre desdits trous de fixation 60, les deux têtes 66, 68 étant situées hors des trous de fixation 60, permettant ainsi de solidariser les deux modules 10, 12, 14, 16 entre eux. Le rivet 62 est alors dans une configuration assemblée, comme représentée sur la figure 4.

Avantageusement, chaque rivet 62 est un rivet monobloc à fixation aveugle.

En position désassemblée, comme illustré sur la figure 3, le rivet 62 comprend alors, outre la partie cylindrique et la première tête 66, une tige 70 introduite dans la partie cylindrique, la première extrémité de la tige 70 faisant saillie hors de la première tête 66.

Cette tige 70 comprend une tête 72 disposée sur la deuxième extrémité de la tige 70. La tête 72 possède une extension radiale plus grande que le diamètre de la partie cylindrique. La tige 70 comprend en outre une zone de moindre résistance 74.

Lorsque le rivet 62 a été introduit dans un trou 60, la tige 70 est tirée hors de la partie cylindrique à travers la première tête 66, par exemple au moyen d'une pince hydraulique à riveter. Cela a pour effet que la tête 72 de la tige 70 déforme la deuxième extrémité de la partie cylindrique et permet la formation de la deuxième tête 68, comme illustré sur la figure 4. Lorsque la deuxième tête 68 est formée, la tige 70 casse au niveau de la partie de moindre résistance 74 et la partie opposée à la tête 72 de la tige 70 est retirée de la partie cylindrique.

L'assemblage du rivet 62 s'effectue ainsi en ne manipulant le rivet 62 que d'un seul côté des modules 10, 12, 14, 16 rendant l'assemblage du rivet 62 monobloc à fixation aveugle simple et rapide.

Le procédé comprend pour finir une étape finale 210 de connexion électrique des modules 10, 12, 14, 16 entre eux. Cette connexion est typiquement réalisée par connexion directe de connecteurs intégrés dans les modules 10, 12, 14, 16.

Le procédé d'assemblage décrit ci-dessus permet un assemblage simple des modules, et donc un poste d'assemblage simplifié.

En effet, le perçage des trous de fixation 60 est réalisé sur chaque module séparément avant l'étape d'assemblage, ce qui facilite à la fois le perçage et l'assemblage.

De plus, grâce au modèle numérique et à la cotation particulière des trous de fixation, la coaxialité des trous de fixation 60 est garantie avec une très grande précision, ce qui permet également une optimisation du nombre de rivets 62 nécessaires à l'assemblage de la caisse 1.

En outre, ce procédé d'assemblage ne produit pas de copeaux pendant l'assemblage, ce qui permet de pré-équiper davantage les modules 10, 12, 14, 16.

Le procédé d'assemblage ne nécessite également pas l'utilisation d'un mastique d'étanchéité entre les modules 10, 12, 14, 16 du fait de la précision du positionnement des trous de fixation 60 et ainsi de la bonne coopération des modules adjacents entre eux.

Le procédé d'assemblage décrit permet donc un assemblage simple et précis des modules 10, 12, 14, 16.

## Revendications

1. Procédé d'assemblage d'une caisse (1) de véhicule ferroviaire, la caisse (1) comprenant au moins un module de châssis (10), au moins un module de paroi (12) et au moins un module de pavillon (16), le procédé comprenant les étapes suivantes :
- création (110) d'un modèle numérique d'au moins un module spécifique (76) parmi les modules de châssis (10), de paroi (12) et de pavillon (16) ;
- cotation (120) dans le modèle numérique de la position de trous de fixation (60) dans le module spécifique (76), la cotation de chaque trou de fixation (60) étant définie au moins par rapport à une arête (22, 28, 46, 56) du module spécifique (76) s'étendant selon une direction de plus grande longueur (A-A', B-B', D-D') du module spécifique (76) et par rapport à un axe (X-X') transversal à la direction de plus grande longueur (A-A', B-B', D-D') du module spécifique (76), l'axe transversal (X-X') étant distinct des arêtes du module spécifique (76), l'axe transversal (X-X') étant un axe médian du module spécifique (76);
- fourniture (140) du module spécifique (76) ;
- perçage (190), par un dispositif de perçage, des trous de fixation (60) dans le module spécifique (76) à la position cotée dans le modèle numérique, chaque trou de fixation (60) étant percé à une distance de la position cotée dans le modèle numérique avec une tolérance de localisation de diamètre 0,25 mm ; et
- assemblage (200) de la caisse (1) par fixation des modules de châssis (10), de paroi (12) et de pavillon (16) entre eux, ledit assemblage comprenant la fixation du module spécifique (76) à au moins une partie de modules (10, 12, 14, 16) adjacents, destinés à être assemblés avec le module spécifique (76), au moyen d'organes de fixation (58) insérés dans les trous de fixation (60) percés dans le module spécifique (76).

2. Procédé d'assemblage selon la revendication 1, dans lequel chacun des modules de châssis (10), de paroi (12) et de pavillon (16) est constitué par un module spécifique (76) et dans lequel l'étape de perçage est réalisée individuellement pour chaque module spécifique préalablement à l'étape d'assemblage.

3. Procédé d'assemblage selon l'une quelconque des revendications précédentes, comprenant, préalablement à l'étape de perçage (190), une étape de localisation (180) d'extrémités du module spécifique (76) suivant la direction de plus grande longueur (A-A' ; B-B', D-D') de ce dernier relativement à un référentiel du dispositif de perçage, qui est avantageusement une machine-outil à commande numérique.

4. Procédé d'assemblage selon l'une quelconque des revendications précédentes, comprenant, préalablement à l'étape de perçage (190), une étape de dégauchissage (160) du module spécifique (76) notamment au niveau de zones destinées à recevoir les trous de fixation (60).

5. Procédé d'assemblage selon l'une quelconque des revendications précédentes, dans lequel les organes de fixation (58) sont constitués par des rivets (62).

6. Procédé d'assemblage selon la revendication 5, dans lequel les rivets (62) sont des rivets monoblocs aveugles.

7. Procédé d'assemblage selon l'une quelconque des revendications précédentes, comprenant, préalablement à l'étape d'assemblage (200) de la caisse (1), une étape de calcul (130) de tenue des organes de fixation (58) au cisaillement.

8. Procédé d'assemblage selon l'une quelconque des revendications précédentes, dans lequel le module spécifique (76) est un module pré-équipé.

9. Procédé d'assemblage selon l'une quelconque des revendications précédentes, comprenant une étape additionnelle de connexion (210) électrique des modules (10, 12, 16) entre eux.

## Patentansprüche

1. Verfahren zum Zusammenbau eines Wagenkastens (1) eines Schienenfahrzeugs, wobei der Wagenkasten (1) mindestens ein Grundrahmenmodul (10), mindestens ein Wandmodul (12) und mindestens ein Dachmodul (16) umfasst, wobei das Verfahren die folgenden Schritte umfasst:
- Erstellen (110) eines digitalen Modells mindestens eines bestimmten Moduls (76) aus den Modulen Grundrahmen (10), Wand (12) und Dach (16);
- Bemaßen (120) der Position von Befestigungslöchern (60) in dem spezifischen Modul (76) in dem digitalen Modell, wobei die Bemaßung jedes Befestigungslochs (60) zumindest in Bezug auf eine Kante (22, 28, 46, 56) des spezifischen Moduls (76), die sich in eine Richtung der größten Länge (A-A', B-B', D-D') des spezifischen Moduls (76) erstreckt, und in Bezug auf eine Achse (X-X') quer zu der Richtung der größten Länge (A-A', B-B', D-D') des spezifischen Moduls (76) definiert ist, wobei die Querachse (X-X') von den Kanten des spezifischen Moduls (76) verschieden ist, wobei die Querachse (X-X') eine zentrale Achse des spezifischen Moduls (76) ist;
- Bereitstellen (140) des jeweiligen Moduls (76);
- Bohren (190) von Befestigungslöchern (60) in dem spezifischen Modul (76) an der bemaßten Position in dem digitalen Modell durch eine Bohrvorrichtung, wobei jedes Befestigungsloch (60) in einem Abstand von der bemaßten Position in dem digitalen Modell mit einer Positionstoleranz von 0,25 mm gebohrt wird; und
- Zusammensetzen (200) des Wagenkastens (1) durch Befestigen der Module Grundrahmen (10), Wand (12) und Dach (16) untereinander, wobei das Zusammensetzen die Befestigung des spezifischen Moduls (76) an mindestens einem Teil der benachbarten Module (10, 12, 14, 16), die vorgesehen sind, mit dem spezifischen Modul (76) zusammengebaut zu werden, mittels Befestigungselementen (58) umfasst, die in die in das spezifische Modul (76) gebohrten Befestigungslöcher (60) eingesetzt werden.

2. Verfahren zum Zusammenbau nach Anspruch 1, bei dem jedes der Module Grundrahmen (10), Wand (12) und Dach (16) durch ein spezifisches Modul (76) gebildet wird und bei dem der Schritt des Bohrens vor dem Schritt des Zusammensetzens für jedes spezifische Modul individuell durchgeführt wird.

3. Verfahren zum Zusammenbau nach einem beliebigen der vorhergehenden Ansprüche, das vor dem Schritt des Bohrens (190) einen Schritt des Lokalisierens (180) der Enden des spezifischen Moduls (76) gemäß der Richtung seiner größten Länge (A-A'; B-B', D-D') in Bezug auf ein Bezugssystem der Bohrvorrichtung umfasst, das vorteilhafterweise eine numerisch gesteuerte Werkzeugmaschine ist.

4. Verfahren zum Zusammenbau nach einem beliebigen der vorhergehenden Ansprüche, das vor dem Schritt des Bohrens (190) einen Schritt des Abrichtens (160) des spezifischen Moduls (76) umfasst, insbesondere in den Bereichen, die zur Aufnahme der Befestigungslöcher (60) bestimmt sind.

5. Verfahren zum Zusammenbau nach einem beliebigen der vorhergehenden Ansprüche, bei dem die Befestigungselemente (58) durch Nieten (62) gebildet werden.

6. Verfahren zum Zusammenbau nach Anspruch 5, bei dem die Nieten (62) einteilige Blindnieten sind.

7. Verfahren zum Zusammenbau nach einem beliebigen der vorhergehenden Ansprüche, das vor dem Schritt des Zusammensetzens (200) des Wagenkastens (1) einen Schritt des Berechnens (130) der Scherfestigkeit der Befestigungselemente (58) umfasst.

8. Verfahren zum Zusammenbau nach einem beliebigen der vorhergehenden Ansprüche, bei dem das spezifische Modul (76) ein vorgerüstetes Modul ist.

9. Verfahren zum Zusammenbau nach einem beliebigen der vorhergehenden Ansprüche, einen zusätzlichen Schritt des elektrischen Verbindens (210) der Module (10, 12, 16) untereinander umfassend.

## Claims

1. Method of assembling a body (1) of a rail vehicle, the body (1) comprising at least one chassis module (10), at least one wall module (12) and at least one roof module (16), the method comprising the following steps:
- creating (110) a numerical model of at least one specific module (76) among the chassis (10), wall (12) and roof (16) modules;
- dimensioning (120) in the numerical model, the position of fixing holes (60) in the specific module (76), the dimension of each fixing hole (60) being defined at least with respect to one edge (22, 28, 46, 56) of the specific module (76) extending in a direction of greater length (A-A', B-B', D-D') of the specific module (76), and with respect to an axis (X-X') transverse to the longer direction (A-A', B-B', D-D') of the specific module (76), the transverse axis (X-X') being distinct from the edges the specific module (76), the transverse axis (X-X') being a median axis of the specific module (76).
- providing (140) the specific module (76);
- drilling (190) with a drilling device, fixing holes (60) in the specific module (76) at the dimensioned position in the numerical model, each fixing hole (60) being drilled at a distance from the position dimensioned in the numerical model with a diameter localization tolerance of 0.25 mm ; and
- assembly (200) of the body (1) by fixing the chassis (10), wall (12) and roof (16) modules together, the assembly comprising the fixing of the specific module (76) to at least one portion of adjacent modules (10, 12, 14, 16) that are to be assembled with the specific module (76), by means of fixing means (58) inserted in the fixing holes (60) that have been drilled in the specific module (76).

2. Method of assembly according to claim 1, wherein each of the chassis (10), wall (12) and roof (16) modules forms a specific module (76), and wherein the drilling step is performed individually for each specific module prior to the assembly step.

3. Method of assembly according to any one of the preceding claims, comprising, prior to the drilling step (190), a step of locating (180) ends of the specific module (76) in the direction of the greater length (A-A', B-B', D-D') of the latter, relative to a reference system of the drilling device, which is advantageously a numerically controlled machine tool.

4. Method of assembly according to any one of the preceding claims, comprising, prior to the drilling step (190), a step of flattening (160) the specific module (76) in particular in areas intended to receive the fixing holes (60).

5. Method of assembly according to any one of the preceding claims, wherein the fixing means (58) are in the form of rivets (62).

6. Method of assembly according to claim 5, wherein the rivets (62) are one-piece blind rivets.

7. Method of assembly according to any one of the preceding claims, comprising, prior to the assembly step (200) of the body (1), a step (130) for calculation of the shear resistance of the fixing means (58).

8. Method of assembly according to any one of the preceding claims, wherein the specific module (76) is a pre-equipped module.

9. Method of assembly according to any one of the preceding claims, comprising an additional step of electrical connection (210) of the modules (10, 12, 16) to each other.
